# FASCICULE DE BREVET EUROPEEN

(11) **EP 0 683 006 B1**
(45) Date de publication et mention de la délivrance du brevet: **01.10.1997**
(21) Numéro de dépôt: 95401118.5
(22) Date de dépôt: 15.05.1995
(51) Int. Cl.: B23K 1/005, H05K 3/34

(54) **Installation de brasage pour composants électroniques**
Lötvorrichtung zum Löten von elektronischen Bauelementen
Soldering equipment for soldering electronic components

(30) Priorité: 16.05.1994 FR 9405933
(43) Date de publication de la demande: 22.11.1995
(73) Titulaire: PRONER COMATEL (Société Anonyme), 93161 Noisy-Le-Grand Cédex (FR)
(72) Inventeur: Arnoul, François, F-77350 Le Mee sur Seine (FR)
(74) Mandataire: Laget, Jean-Loup

(56) Documents cités:
- EP-A- 0 251 257
- DE-A- 3 925 814

## Description

L'invention concerne une installation de brasage pour composants électroniques, et plus particulièrement de brasage des contacts sur les plaquettes de composants hybrides.

On connaît des contacts du type lame de raccordement électrique en matériau conducteur résilient, apte à assurer un maintien élastique, et à coopérer avec un revêtement en matériau malléable à braser destiné à être fondu pour assurer une connexion électrique.

Pour braser ces contacts sur les composants hybrides, il est connu d'utiliser trois techniques : le four, la barre à braser du genre thermode, et la rampe à air chaud.

Dans un four, la totalité du composant est chauffée à la température de fusion, ce qui entraîne une refusion du circuit imprimé et des composants électroniques déjà brasés, avec un risque de modification des caractéristiques électriques du circuit et de détérioration de la qualité des brasures des composants électroniques discrets brasés sur le circuit.

Avec une barre à braser du genre thermode, seule la partie à braser des contacts et du circuit est chauffée par la barre. L'opération de brasage ne peut pas être effectuée en continu, mais seulement pas à pas ce qui rend onéreuse cette technique de brasage.

Dans le cas de brasage par rampe à air chaud, de l'azote chaud est soufflé au moyen d'une buse devant laquelle défile le composant. De ce fait, la totalité du composant est chauffée, ce qui entraîne les mêmes inconvénients que le brasage au four, avec en plus, le risque de soufflage de la brasure rendue liquide par le chauffage, et le coût lié à la consommation d'azote.

L'un des buts de l'invention est de proposer une installation de chauffage qui assure un chauffage limité à la partie requise pour le brasage.

Un autre but de l'invention est de proposer une installation de chauffage fonctionnant en continu.

Un autre but encore de l'invention est de proposer une installation qui ne mette en jeu qu'une quantité limitée d'azote, ou de gaz neutre en général.

L'invention a pour objet une installation de brasage pour composants électroniques, constitués d'une plaquette de circuit imprimé ou hybride et de contacts comportant chacun une pince de fixation à la plaquette, ladite pince présentant une partie en contact avec la plaquette destinée à être solidarisée à la plaquette au moyen d'une brasure, ladite installation de brasage présentant une zone de préchauffage et une zone de chauffage, caractérisée en ce que la zone de chauffage est munie de tubes à rayonnement infra-rouge équipés de réflecteurs définissant des fentes devant lesdits tubes, et en ce que les tubes sont disposés parallèlement entre eux, la distance des fentes en regard correspondant sensiblement à la largeur d'un composant, de sorte que lorsque les composants défilent en continu dans la zone de chauffage, seule la partie de ces composants située devant lesdites fentes est soumise au chauffage suffisant pour assurer la fusion de la brasure.

Selon une caractéristique de l'invention, la zone de préchauffage est inertée, en étant placée sous atmosphère essentiellement neutre.

L'invention a également pour objet une utilisation de l'installation selon l'invention, caractérisée en ce que le contact comporte au moins une pince présentant une couche de brasure sur sa partie en contact avec la plaquette.

D'autres caractéristiques ressortent de la description qui suit, faite avec référence au dessin annexé sur lequel :
- la figure 1 est une vue en plan d'un exemple de réalisation d'une installation de brasage selon l'invention ;
- la figure 2 est une vue en coupe transversale de la zone de chauffage de l'installation de la figure 1 ;
- la figure 3 représente un exemple de réalisation d'un contact particulier avant passage dans l'installation selon l'invention ;
- la figure 4 représente le contact de la figure 3 après passage dans l'installation selon l'invention.

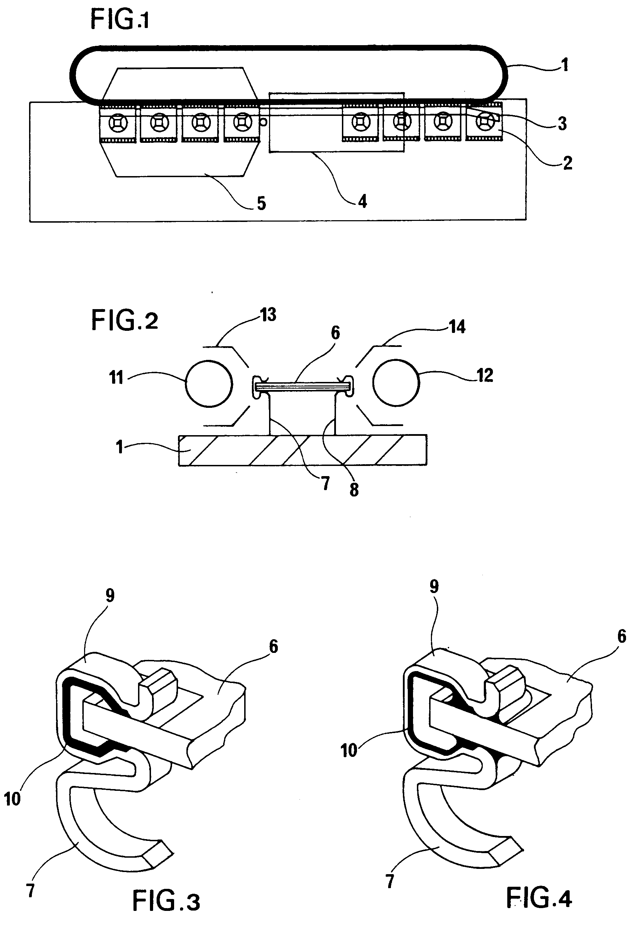

Dans le schéma simplifié de la figure 1, l'installation est symbolisée par un convoyeur 1, une zone de préchauffage 4 et une zone de chauffage 5. Les composants 2 à braser sont guidés par un rail 3, et passent successivement dans la zone de préchauffage 4 et la zone de chauffage 5.

Dans la vue transversale de la figure 2, les composants 2 sont portés par le convoyeur 1. Ils se composent essentiellement d'une plaquette 6 et de deux séries de contacts 7 et 8 qui sont déjà mécaniquement mis en place.

Ces contacts présentent une patte qui s'étend de la plaquette vers le convoyeur 1, et une pince prenant appui sur les deux faces de la plaquette. Dans l'épaisseur du métal constituant le contact, sur la partie intérieure en contact avec la plaquette, est disposée la brasure, sous forme d'une couche. C'est cette couche de brasure qui doit être fondue pour assurer le brasage du contact sur la plaquette.

Un exemple de réalisation d'un contact de ce type est représenté figure 3. La pince 9 porte dans son épaisseur, du côté intérieur, une couche 10 de brasure.

Dans la zone de chauffage 5, les contacts sont exposés à un rayonnement infra-rouge émis par des tubes 11, 12 parallèles entre lesquels passent les composants. Ces tubes 11, 12 sont entourés par des réflecteurs 13, 14 respectivement, qui concentrent l'émission du rayonnement infra-rouge sur les fentes devant lesquelles défilent les pinces 9 des contacts à braser. La distance entre ces fentes correspond sensiblement à la largeur d'un composant. En raison de cette disposition, le rayonnement infra-rouge ne chauffe qu'une région limitée correspondant essentiellement aux pinces 9, sans que l'ensemble du composant soit chauffé. Sous l'action du rayonnement infrarouge, la couche 10 de brasure fond et se répartit sous le raccordement mécanique pour assurer un raccordement électrique satisfaisant entre le contact 7 et la plaquette 6 du composant 2.

L'installation de brasage selon l'invention fonctionne de la manière suivante : les composants 2 sont préalablement équipés des contacts sur deux de leurs bords opposés, ces contacts étant soit individuels, soit de préférence en barrettes constituées de plusieurs contacts identiques encore solidaires par leurs extrémités opposées à la pince. Dans ce dernier cas, ces extrémités sont ensuite coupées. Les composants 2 sont ainsi constitués chacun d'une plaquette de circuit imprimé, éventuellement munie de composants électroniques discrets dans le cas de circuits hybrides, et de deux séries de contacts situées en regard l'une de l'autre. Ces composants sont mis en position avec la plaquette 6 en haut, parallèle au convoyeur 1, et ils reposent sur le convoyeur 1 par leurs contacts.

Ils sont ensuite orientés de façon que les contacts soient alignés dans le sens de la progression des composants 2. Il sont mis en position correcte par le rail de guidage 3 et progressent, sur la figure 1, de la droite vers la gauche.

Ils traversent d'abord la zone 4 de préchauffage. Dans cette zone, l'ensemble du composant et des contacts est chauffé à une température d'environ 100° C pour éliminer les oxydes métalliques des surfaces à braser. Cette préparation de surface est classique et se réalise en général avec l'apport d'un produit décapant appelé flux, d'où son nom usuel de fluxage.

Dans l'installation selon l'invention, il est possible de réaliser le préchauffage sous azote, ce qui n'est pas cher en raison des dimensions limitées de la zone de préchauffage, et dans ce cas, l'apport de flux n'est pas nécessaire.

Dans leur progression continue, les composants 2 passent alors dans la zone de chauffage 5. Les pinces 9 des contacts défilent devant les fentes des réflecteurs 13, 14 où elles sont chauffées par le rayonnement infra-rouge jusqu'à une température de l'ordre de 250° C nécessaire et suffisante pour que la brasure 10 fonde et assure le raccordement entre plaquette et contact sans que l'ensemble du composant 2 soit soumis à cette température. L'installation réalise ainsi un chauffage localisé, dans une zone de proximité des tubes à rayonnement infra-rouge.

L'invention décrite en référence à un mode de réalisation particulier comprend également toute modification de forme et toute variante de réalisation dans le cadre de l'invention tel que défini par les revendications : à titre d'atmosphère essentiellement neutre équivalente à l'azote, on peut utiliser toute atmosphère gazeuse contenant moins de 100 p.p.m. (parties par million) d'oxygène ; à titre de pince de contact, on peut utiliser en particulier des pinces de contact présentant une couche de brasure sur sa partie en contact avec la plaquette.

## Revendications

1. Installation de brasage pour composants électroniques constitués d'une plaquette de circuit imprimé ou hybride et de contacts comportant chacun une pince de fixation à la plaquette, ladite pince présentant une partie en contact avec la plaquette destinée à être solidarisée à la plaquette au moyen d'une brasure, ladite installation de brasage présentant une zone de préchauffage et une zone de chauffage, caractérisée en ce que la zone de chauffage est munie de tubes (11, 12) à rayonnement infra-rouge équipés de réflecteurs (13, 14) définissant des fentes devant lesdits tubes (11, 12), et en ce que les tubes (11, 12) sont disposés parallèlement entre eux, la distance des fentes en regard correspondant sensiblement à la largeur d'un composant (2), de sorte que lorsque les composants défilent en continu dans la zone de chauffage, seule la partie de ces composants située devant lesdites fentes soit soumise au chauffage suffisant pour assurer la fusion de la brasure.

2. Installation selon la revendication 1, caractérisée en ce que la zone de préchauffage est inertée, en étant placée sous atmosphère essentiellement neutre.

3. Utilisation de l'installation de brasage selon la revendication 1 ou la revendication 2, caractérisée en ce que le contact (7) comporte au moins une pince (9) présentant une couche de brasure (10) sur sa partie en contact avec la plaquette (6).

## Claims

1. A soldering installation for electronic components formed of a printed circuit board or hybrid circuit board and contacts each comprising a clip for fixing to the board, said clip having a part in contact with the board which is intended to be connected to the board by means of solder, said soldering installation having a preheating zone and a heating zone, characterized in that the heating zone is provided with infrared radiation tubes (11, 12) equipped with reflectors (13, 14) which defins slots in front of said tubes (11, 12), and in that the tubes (11, 12) are arranged in parallel, the distance of the facing slots corresponding substantially to the width of a component (2), such that when the components pass continuously into the heating zone, only the part of these components located in front of said slots is subjected to sufficient heating to ensure melting of the solder.

2. An installation according to Claim 1, characterized in that the preheating zone is rendered inert, being placed under a substantially neutral atmosphere.

3. The use of the soldering installation according to Claim 1 or Claim 2, characterized in that the contact (7) comprises at least one clip (9) having a layer of solder (10) on its part in contact with the board (6).

## Patentansprüche

1. Lötvorrichtung zum Löten von elektronischen Bauelementen, die aus einer gedruckten Leiterplatte oder einer Hybrid-Leiterplatte und Kontakten bestehen, von denen jeder einen Klemmanschluß zur befestigung an der Leiterplatte hat, wobei der Klemmanschluß einen in Kontakt mit der Leiterplatte befindlichen Abschnitt aufweist, der dazu bestimmt ist, sich mittels eines Lötmittels mit der Leiterplatte zu vereinigen,
wobei die Lötvorrichtung einen Vorheizbereich und einen Heizbereich aufweist,
**dadurch gekennzeichnet, daß**
der Heizbereich mit Infrarot-Strahlungsröhren (**11, 12**) versehen ist, die mit vor den Röhren (**11, 12**) einen Spalt definierenden Reflektoren (**13, 14**) ausgestattet sind, und
die Röhren (**11, 12**) parallel zueinander angeordnet sind, wobei der Abstand der betreffenden Spalte im wesentlichen der Größe eines Bauelements (**2**) entspricht, so daß im Fall der kontinuierlich in dem Heizbereich entlang laufenden Bauelemente lediglich der vor den Spalten befindliche Bereich der Bauelemente einer Erwärmung ausgesetzt ist, die ausreicht, um die Bindung des Lötmittels sicherzustellen.

2. Vorrichtung nach Anspruch 1,
**dadurch gekennzeichnet, daß**
der Vorheizbereich inert ist, da er in einer im wesentlichen neutralen Umgebung angeordnet ist.

3. Verwendung der Vorrichtung nach Anspruch 1 oder 2,
**dadurch gekennzeichnet, daß**
der Kontakt (**7**) zumindest einen Klemmanschluß (**9**) umfaßt, der an seinem in Kontakt mit der Leiterplatte (**6**) befindlichen Abschnitt eine Lötmittelschicht (**10**) aufweist.
